(19) **Europäisches Patentamt / European Patent Office / Office européen des brevets**

(11) **EP 3 265 790 B1**

(12) **FASCICULE DE BREVET EUROPEEN**

(45) Date de publication et mention de la délivrance du brevet:
**29.09.2021 Bulletin 2021/39**

(51) Int Cl.:
**G01R 33/60** (2006.01)   **G01N 24/10** (2006.01)

(21) Numéro de dépôt: **16712959.2**

(22) Date de dépôt: **02.03.2016**

(86) Numéro de dépôt international:
**PCT/FR2016/050467**

(87) Numéro de publication internationale:
**WO 2016/139419 (09.09.2016 Gazette 2016/36)**

(54) **PROCEDE ET DISPOSITIF DE SPECTROSCOPIE DE RESONANCE DE SPIN ELECTRONIQUE DE TRES HAUTE SENSIBILITE**

VERFAHREN UND VORRICHTUNG FÜR HÖCHST EMPFINDLICHE ELEKTRONENSPINRESONANZSPEKTROSKOPIE

METHOD AND DEVICE FOR VERY HIGH SENSITIVITY ELECTRON SPIN RESONANCE SPECTROSCOPY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.03.2015 FR 1551786**

(43) Date de publication de la demande:
**10.01.2018 Bulletin 2018/02**

(73) Titulaire: **Commissariat à l'Énergie Atomique et aux Énergies Alternatives 75015 Paris (FR)**

(72) Inventeurs:
• **BERTET, Patrice**
  **75013 Paris (FR)**
• **MOELMER, Klaus**
  **8200 Aarhus N (DK)**

(74) Mandataire: **Cabinet Beau de Loménie 158, rue de l'Université 75340 Paris Cedex 07 (FR)**

(56) Documents cités:
• SIGILLITO A J ET AL: "Fast, low-power manipulation of spin ensembles in superconducting microresonators", APPLIED PHYSICS LETTERS, AMERICAN INSTITUTE OF PHYSICS, 2 HUNTINGTON QUADRANGLE, MELVILLE, NY 11747, [Online] vol. 104, no. 22, 2 juin 2014 (2014-06-02) , XP012186153, ISSN: 0003-6951, DOI: 10.1063/1.4881613 [extrait le 2014-06-05] cité dans la demande
• YARON ARTZI ET AL: "Induction-detection electron spin resonance with spin sensitivity of a few tens of spins", APPLIED PHYSICS LETTERS, vol. 106, no. 8, 23 février 2015 (2015-02-23), page 84104, XP055233646, 2 Huntington Quadrangle, Melville, NY 11747 ISSN: 0003-6951, DOI: 10.1063/1.4913806
• MALISSA H ET AL: "Superconducting coplanar waveguide resonators for low temperature pulsed electron spin resonance spectroscopy", REVIEW OF SCIENTIFIC INSTRUMENTS, AIP, MELVILLE, NY, US, vol. 84, no. 2, 26 février 2013 (2013-02-26), pages 25116-25116, XP012174622, ISSN: 0034-6748, DOI: 10.1063/1.4792205 [extrait le 2013-02-26] cité dans la demande
• Y. KUBO ET AL: "Electron spin resonance detected by a superconducting qubit", PHYSICAL REVIEW. B, CONDENSED MATTER AND MATERIALS PHYSICS, vol. 86, no. 6, 10 août 2012 (2012-08-10), XP055233541, US ISSN: 1098-0121, DOI: 10.1103/PhysRevB.86.064514

- **TWIG YGAL ET AL: "Sensitive surface loop-gap microresonators for electron spin resonance", REVIEW OF SCIENTIFIC INSTRUMENTS, AIP, MELVILLE, NY, US, vol. 81, no. 10, 21 octobre 2010 (2010-10-21), pages 104703-104703, XP012145495, ISSN: 0034-6748, DOI: 10.1063/1.3488365 cité dans la demande**
- **CASTELLANOS-BELTRAN M ET AL: "Widely tunable parametric amplifier based on a superconducting quantum interference device array resonator", APPLIED PHYSICS LETTERS, AMERICAN INSTITUTE OF PHYSICS, 2 HUNTINGTON QUADRANGLE, MELVILLE, NY 11747, vol. 91, no. 8, 22 août 2007 (2007-08-22), pages 83509-83509, XP012100804, ISSN: 0003-6951, DOI: 10.1063/1.2773988 cité dans la demande**
- **N. BERGEAL ET AL: "Phase-preserving amplification near the quantum limit with a Josephson ring modulator", NATURE, vol. 465, no. 7294, 6 mai 2010 (2010-05-06), pages 64-68, XP055233824, United Kingdom ISSN: 0028-0836, DOI: 10.1038/nature09035 cité dans la demande**
- **BACHAR GIL ET AL: "Nonlinear induction detection of electron spin resonance", APPLIED PHYSICS LETTERS, AMERICAN INSTITUTE OF PHYSICS, 2 HUNTINGTON QUADRANGLE, MELVILLE, NY 11747, vol. 101, no. 2, 9 juillet 2012 (2012-07-09), pages 22602-22602, XP012163862, ISSN: 0003-6951, DOI: 10.1063/1.4734500 [extrait le 2012-07-12]**

## Description

### Domaine de l'invention

La présente invention concerne un dispositif et un procédé destinés à effectuer la spectroscopie de résonance de spin électronique (en abrégé ESR selon l'expression anglaise « Electronic Spin Resonance ») avec une sensibilité accrue par rapport à l'état de l'art.

La spectroscopie ESR a des applications notamment en biologie structurale, physique du solide, archéologie.

### Art antérieur

Les spectromètres actuels ont une sensibilité qui leur permet de détecter typiquement $10^9$ spins en une seconde de temps d'intégration.

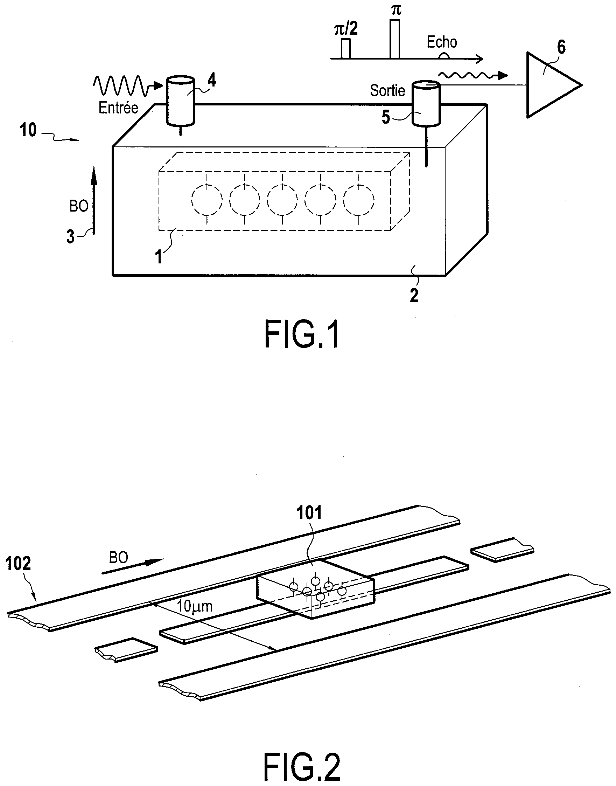

Le but d'un spectromètre ESR 10 est de détecter et de caractériser des spins électroniques dans un échantillon donné 1. Pour cela, l'échantillon 1 est inséré dans un résonateur électromagnétique 2 ayant une fréquence de résonance $\omega r$ dans le domaine micro-onde (typiquement de 5 à 10GHz), et un facteur de qualité Q (voir figure 1).

Un champ magnétique B0 est appliqué à l'échantillon 1 selon la direction de la flèche 3 par une bobine ou d'autres dispositifs de création d'un champ magnétique, non représentés, afin d'amener la fréquence de transition des spins (donnée par $\omega s = \gamma B0$, $\gamma$ étant le facteur gyromagnétique des spins) à résonance avec la fréquence de résonance $\omega r$.

Cette résonance magnétique est détectée grâce à un signal micro-onde qui est injecté dans la cavité à la fréquence $\omega r$ par un dispositif 4 et récupéré en sortie de l'échantillon 1 par un dispositif 5 pour être amplifié par un dispositif amplificateur 6.

La transmission T de ce signal est réduite lorsque $\omega s = \omega r$, car les spins absorbent alors ce signal micro-onde, ce qui se manifeste par l'apparition de fléchissement de résonance sur la courbe T(B0). La fréquence et largeur des fléchissements (encore appelés « dips »), ainsi que leur amplitude relative, permettent d'extraire un ensemble d'informations sur l'échantillon 1.

Ce mode d'utilisation d'un spectromètre s'appelle « spectroscopie de spins CW » (selon l'expression anglaise « Continuous Wave-EPR »).

Un autre mode d'utilisation très utilisé (appelé « EPR puisée ») qui met en œuvre un dispositif tel que celui de la figure 1 consiste à utiliser des séquences d'impulsions brèves de micro-onde qui exercent une rotation du spin d'un angle de Rabi bien défini.

L'une des séquences les plus utilisées s'appelle l'écho de spin. Il consiste à appliquer une première impulsion exerçant une rotation d'angle $\pi/2$ sur les spins, suivie après une durée $\tau$ d'une deuxième impulsion exerçant une rotation d'angle $\pi$. Les spins satisfaisant la condition de résonance $\omega s = \omega r$ émettent alors un signal d'écho à l'instant $2\tau$.

La dépendance de l'amplitude de ce signal d'écho en fonction des paramètres (champ magnétique, angle, délai $\tau$ entre les impulsions, ...) contient toutes les informations pouvant être extraites de l'échantillon.

La détection du signal d'écho de spin est donc essentielle et constitue la clé de voûte de la résonance paramagnétique électronique.

La puissance maximale P émise lors d'un écho de spins dans le câble connectant le résonateur 1 à la chaîne de détection 6 est donnée par une formule simple: $P = \hbar \omega r N^2 g^2 / \kappa$, N étant le nombre de spins contenus dans l'échantillon, g étant la « constante de couplage » d'un spin au champ micro-onde de la cavité, et $\kappa = \omega r / Q$ le taux d'amortissement du champ dans le résonateur micro-onde.

La durée de l'impulsion d'écho dépend de l'échantillon, mais est donnée approximativement par le « temps d'induction libre » $T_2^*$.

La sensibilité du spectromètre peut alors être quantifiée par le nombre minimal de spins Nmin pouvant être détectés avec un rapport-signal-sur-bruit de 1 lors d'un écho de spin.

Ce nombre dépend clairement de la quantité de bruit ajoutée par le premier amplificateur de la chaîne de détection micro-onde 6 caractérisée par sa température de bruit $T_N$. La dégradation du rapport signal-sur-bruit lors de l'amplification est donnée par le nombre de photons de bruit rajouté par l'amplificateur donné par $n = 1/(e^{\hbar \omega r / kT N}-1)$.

Les amplificateurs micro-ondes habituels fonctionnent tous dans la limite où $kT_N \gg \hbar \omega r$ si bien que $n \approx kT_N / \hbar \omega r$.

Le nombre minimal de spins pouvant être détecté par le spectromètre en un écho de spin est alors calculé en égalant le nombre de photons émis par les spins lors d'un écho $\left( T_2^* P / \hbar \omega r \right)$ au nombre de photons de bruit émis pendant $T_2^*$ dans une bande passante $1/T_2^*$ (c'est-à-dire $n$), ce qui implique que

$$N_{\min} \approx \coth\left(\frac{\hbar \omega r}{2kT}\right)\frac{1}{g}\sqrt{\frac{n\kappa}{T_2^*}}$$

(le premier terme en coth étant dû à la polarisation d'équilibre des spins à la température T).

Dans un spectromètre habituel, le résonateur 2 est une boîte métallique qui contient l'échantillon 1, et le champ micro-onde à l'intérieur du résonateur 2 occupe un volume d'environ $\lambda^3$, $\lambda$ étant la longueur d'onde à la fréquence $\omega r$. Cela résulte en une constante de couplage typique g = $2\pi$ x 5 mHz. L'amplificateur 6 à température ambiante rajoute environ n = $10^3$ photons de bruit. Le facteur de qualité est typiquement de 2000. Le facteur de polarisation des spins à température ambiante est

$$\coth\left(\frac{\eta\omega r}{2kT}\right) \approx 10^3$$

. Cela conduit à une sensibilité $N_{min} \approx 10^{13}$ spins détectables en un écho de spin pour un spectromètre conventionnel à température ambiante.

Récemment de nouveaux types de spectromètres ont été développés, basés sur des micro-résonateurs 102. Il s'agit de résonateurs micro-ondes fabriqués à partir de films minces métalliques (voir la figure 2).

Le volume du mode peut alors être beaucoup plus faible que $\lambda^3$ si bien que la constante de couplage peut être plus large, atteignant g = $2\pi$ x 1 à 20 Hz. Des micro-résonateurs 102 ont été réalisés avec une géométrie dite de « loop-gap » avec des films minces en métal normal (voir par exemple l'article de Y. Twig, E. Suhovoy, A. Blank, Rev. Sci. Inst. 81, 104703 (2010) et l'article de Y. Artzi, Y. Twig, A. Blank, Appl. Phys. Lett. 104, 84104 (2015)).

Selon un mode de réalisation, des micro-résonateurs 102 ont été réalisés en géométrie de guide d'onde coplanaire en métal supraconducteur (voir l'exemple de la figure 2), comme décrit par exemple dans l'article de H. Malissa, D.I. Schuster, A.M. Tyryshkin, A.A. Houck, S.A. Lyon, Rev. of Sci. Instr. 84, 025116 (2013).

En travaillant à 4 K pour augmenter la polarisation de spins, et en utilisant par ailleurs de meilleurs amplificateurs refroidis à 4 K, pour lesquels on obtient jusqu'à n = 10 à 20 photons de bruit, la sensibilité a été augmentée jusqu'à une valeur record de $N_{min} \approx 10^7$ spins en un écho de spin, qui représente la sensibilité la plus élevée publiée dans la littérature à ce jour (voir l'article de A.J. Sigillito et al., Appl. Phys. Lett. 104, 222407 (2014)). Il est toutefois souhaitable de pouvoir encore améliorer une telle sensibilité.

Objet et description succincte de l'invention

L'objet de l'invention est de proposer un procédé et un dispositif pour gagner jusqu'à treize ordres de grandeur par rapport aux spectromètres ESR habituels, et jusqu'à sept ordres de grandeur par rapport à l'état de l'art, ce qui permettrait donc de détecter un seul spin en une seconde de mesure environ.

Les applications ouvertes par l'invention incluent la spectroscopie ESR d'une seule protéine, d'une seule cellule biologique, ainsi que la réalisation d'un ordinateur quantique à base de spins dans le solide.

Ces buts sont atteints grâce à un dispositif de spectroscopie de résonance de spin de très haute sensibilité, selon la revendication indépendante 1, pour la détection et la caractérisation de spins électroniques dans un échantillon donné, comprenant un micro-résonateur électromagnétique, ayant une fréquence de résonance cor dans le domaine micro-onde et un facteur de qualité Q et dans lequel est inséré l'échantillon, un dispositif de création d'un champ magnétique B0 dans l'échantillon pour amener à résonance avec la fréquence de résonance ωr une fréquence ωs de transition des spins, telle que ωs=γB0, où γ est un facteur gyromagnétique des spins ; un dispositif de détection de spins recevant des signaux du micro-résonateur électromagnétique auquel est associé l'échantillon et comprenant au moins un amplificateur bas-bruit fonctionnant à une température comprise entre 1 et 10 K, une série d'amplificateurs et un démodulateur fonctionnant à température ambiante, caractérisé en ce que le micro-résonateur électromagnétique est en métal supraconducteur et est réalisé à l'échelle nanométrique en comprenant une zone active constituée par une constriction essentiellement parallélépipédique avec une épaisseur comprise entre 8 et 30 nm, une largeur comprise entre 10 et 500 nm et une longueur comprise entre 100 et 5000 nm, ledit échantillon étant disposé sur ladite constriction, les spins présents au sein de ladite zone active étant couplés avec une constante de couplage de 1 à 10 kHz.

Le micro-résonateur peut être réalisé préférentiellement :

- en niobium, NbN, ou en NbTiN pour un fonctionnement en dessous de 5K ;
- en aluminium pour un fonctionnement en dessous de 200 mK ; ou
- en TiN pour un fonctionnement en dessous de 2K.

Selon un mode particulier de réalisation, le dispositif comprend un amplificateur paramétrique Josephson disposé en amont de l'amplificateur bas-bruit et fonctionnant à des températures T vérifiant $T \leq \hbar\omega r/k_B$, où $\hbar$ est la constante de Planck réduite et $k_B$ est la constante de Boltzmann (dont la valeur est $k_B$ = 1,38 J/K = 1,38 x $10^{-23}$ m$^2$kgs$^{-2}$K$^{-1}$).

Si la fréquence de travail est d'environ ωr/$2\pi$ = 5 à 10 GHz, la température de travail adéquate sera donc dans les 10 à 200 mK.

Si la fréquence de travail est plus élevée ωr/$2\pi$ = 20 à 40 GHz, il sera possible de travailler à une température d'environ 1 à 3K, qui peut être atteinte sans utiliser de cryogénie à dilution.

Dans ce cas, selon un mode de réalisation avantageux, le dispositif comprend en outre un amplificateur paramétrique Josephson supplémentaire fonctionnant à des températures T vérifiant $T \leq \hbar\omega r/k_B$, et disposé de telle sorte que sa sortie soit connectée à l'entrée du micro-résonateur afin de produire un « vide comprimé » qui est un état quantique du champ électromagnétique dans lequel le bruit sur l'une des deux quadratures est réduit par rapport au bruit quantique du vide.

Le dispositif de détection de spins peut être du type à onde continue et comprend alors un dispositif d'injection d'un signal micro-onde à la fréquence cor dans le micro-résonateur électromagnétique.

Selon une alternative possible, le dispositif de détection de spins est du type à ondes pulsées et comprend un dispositif d'injection de séquences d'impulsions brèves de micro-onde à la fréquence ωr dans le micro-résonateur électromagnétique pour exercer une rotation du spin d'un angle de Rabi bien défini.

L'invention a encore pour objet un procédé de spectroscopie de résonance de spin de très haute sensibilité, selon la revendication indépendante 7, pour la détection et la caractérisation de spins électroniques dans un échantillon donné, comprenant une étape de réalisation d'un micro-résonateur électromagnétique, ayant une fréquence de résonance ωr dans le domaine micro-onde et un facteur de qualité Q et auquel est associé l'échantillon ; une étape de création d'un champ magnétique B0 dans l'échantillon pour amener à résonance avec la fréquence de résonance ωr une fréquence ωs de transition des spins, telle que ωs=γB0, où γ est un facteur gyromagnétique des spins ; une étape de détection de spins recevant des signaux du micro-résonateur électromagnétique auquel est associé l'échantillon en utilisant au moins un amplificateur bas-bruit fonctionnant à une température comprise entre 1 et 10 K, ainsi qu'une série d'amplificateurs et un démodulateur fonctionnant à température ambiante, caractérisé en ce que dans l'étape de réalisation du micro-résonateur électromagnétique on choisit un micro-résonateur électromagnétique en métal supraconducteur qui est réalisé à l'échelle nanométrique en comprenant une zone active constituée par une constriction essentiellement parallélépipédique dont les dimensions sont : une épaisseur de 8 à 30 nm, une largeur de 10 à 500 nm et une longueur comprise entre 100 et 5000 nm, ledit échantillon étant disposé sur ladite constriction, les spins présents au sein de ladite zone active étant couplés avec une constante de couplage de 1 à 10 kHz.

Selon un mode de réalisation particulier, dans l'étape de détection de spins, on dispose en amont de l'amplificateur bas-bruit un amplificateur paramétrique Josephson fonctionnant à des températures T vérifiant $T \leq \hbar\omega r / k_B$, où $\hbar$ est la constante de Planck réduite et $k_B$ est la constante de Boltzmann (dont la valeur est $k_B$ = 1,38 J/K = 1,38 x $10^{-23}$ $m^2kgs^{-2}K^{-1}$).

Si la fréquence de travail est d'environ ωr/2π = 5 à 10 GHz, la température de travail adéquate sera donc dans les 10 à 200 mK.

Si la fréquence de travail est plus élevée ωr/2π = 20 à 40 GHz, il sera possible de travailler à une température d'environ 1 à 3 K, qui peut être atteinte sans utiliser de cryogénie à dilution.

Dans ce cas où un amplificateur paramétrique Josephson est disposé en amont de l'amplificateur bas-bruit, selon un mode de réalisation avantageux, dans l'étape de réalisation d'un micro-résonateur électromagnétique, on dispose un amplificateur paramétrique Josephson supplémentaire fonctionnant à des températures T vérifiant $T \leq \hbar\omega r / k_B$, de telle sorte que sa sortie soit connectée à l'entrée du micro-résonateur afin de produire un « vide comprimé » qui est un état quantique du champ électromagnétique dans lequel le bruit sur l'une des deux quadratures est réduit par rapport au bruit quantique du vide.

Selon la présente invention, plusieurs caractéristiques contribuent chacune à améliorer la sensibilité d'un spectromètre ESR tout en en préservant le principe de base.

Avec l'ensemble des innovations proposées ici la sensibilité d'un spectromètre ESR peut atteindre un nombre minimal de spins détectés en un écho $N_{min} \approx 1$, c'est-à-dire un gain de treize ordres de grandeur par rapport à un spectromètre conventionnel et de sept ordres de grandeur par rapport à la meilleure valeur publiée à ce jour, correspondant à un temps de mesure respectivement $10^{26}$ et $10^{14}$ fois plus court.

Brève description des dessins

D'autres caractéristiques et avantages de l'invention ressortiront de la description suivante de modes particuliers de réalisation, donnés à titre d'exemples non limitatifs en référence aux dessins annexés, sur lesquels :

- La figure 1 est un schéma représentant la structure de base d'un spectromètre ESR,
- La figure 2 est une vue schématique en perspective montrant un exemple de spectromètre ESR à base de micro-résonateur coplanaire,
- La figure 3 est une vue schématique en perspective d'un nano-résonateur pour spectroscopie ESR selon un aspect de l'invention,
- La figure 3A est une vue agrandie d'une partie du nano-résonateur de la figure 3 montrant une constriction recevant un échantillon nanométrique,
- La figure 4 est un schéma d'un spectromètre ESR à base d'amplificateur paramétrique Josephson selon un deuxième aspect de l'invention, et
- La figure 5 est un schéma d'un mode particulier de réalisation constituant un perfectionnement du spectromètre ESR de la figure 4 en vue de produire un écho non-bruyant.

Description détaillée de modes particuliers de réalisation de l'invention

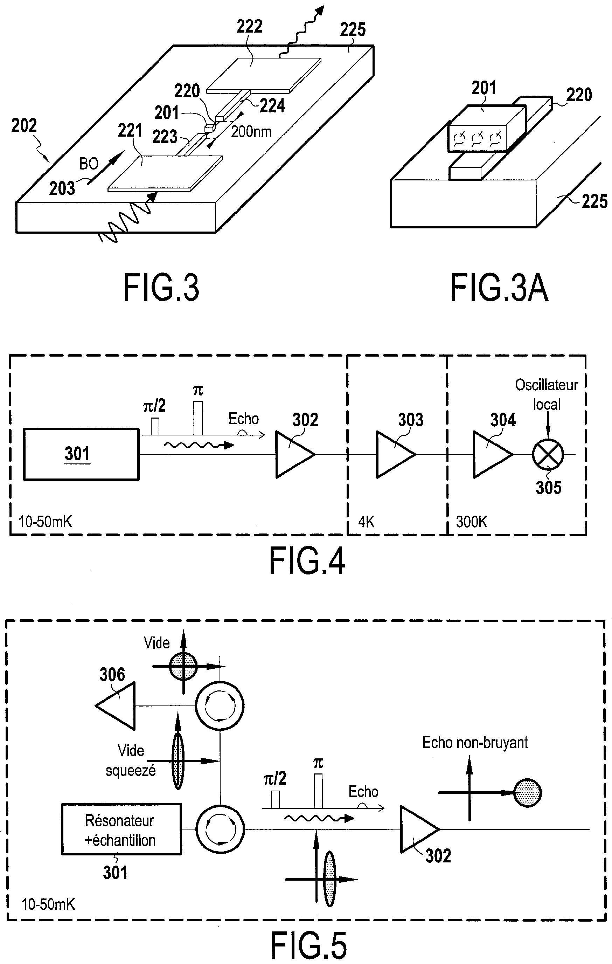

Selon un premier aspect de l'invention, qui est représenté sur la figure 3, on met en oeuvre dans un spectromètre ESR un micro-résonateur 202 qui est à l'échelle nanométrique.

Il s'agit, au sein de la partie inductive d'un micro-résonateur (par exemple le micro-résonateur 202 en géométrie coplanaire représenté sur la figure 3), d'introduire une petite zone 220 où les dimensions du résonateur deviennent beaucoup plus faibles, typiquement entre 10 et 500 nm (voir les figures 3 et 3A). Une telle constriction 220 est réalisable en utilisant des techniques de lithographie électronique standard. On obtient ainsi une « zone active » de dimensions typiques $(100nm)^3$ au sein de laquelle les spins présents seront couplés avec une constante de couplage pouvant atteindre de 1 à 10 kHz, environ deux ordres de grandeur supérieure à ce qui a été réalisé jusqu'à maintenant.

Sur la figure 3, on voit un substrat 225 sur lequel sont déposées des couches métalliques 221 et 222 en forme de plaques correspondant à la partie capacitive du résonateur du spectromètre ESR de la figure 1, qui permet aussi le couplage aux guides d'onde de mesure (non montrés). La géométrie exacte de cette partie capacitive peut être adaptée par rapport à celle indiquée sur le schéma, par exemple une capacité interdigitée est utilisable. Les couches métalliques 221 et 222 sont alignées selon une direction 203 correspondant à la direction du champ magnétique appliqué B0. Les couches métalliques 221 et 222 sont reliées entre elles par des pistes conductrices 223, 224 plus étroites alignées entre elles selon la direction 203 et réunies par une partie encore plus étroite formant constriction 220 sur laquelle est disposé un échantillon 201 à analyser (voir les figures 3 et 3A).

La constriction 220 de forme parallélépipédique peut présenter par exemple une section de 20 nm x 20 nm et une longueur de 200 nm.

Plus généralement, la constriction 220 essentiellement parallélépipédique a une épaisseur de 8 à 30 nm, une largeur de 10 à 500 nm, et une longueur comprise entre 100 et 5000 nm.

De façon plus particulière, les dimensions de la constriction 220 et celles de l'échantillon 201 sont adaptées pour être compatibles entre elles.

En particulier, ce type de nano-résonateur 202 est bien adapté pour mesurer des échantillons 201 de taille typique ∼100nm, tels que des échantillons biologiques, où la quantité de matériel disponible est très faible.

Le résonateur 202 doit impérativement être fabriqué en métal supraconducteur (par exemple le Niobium ou le NbN ou le NbTiN en-dessous de 5 K, l'aluminium en-dessous de 200 mK, ou bien le TiN en-dessous de 2 K) pour que son facteur de qualité Q soit suffisamment élevé pour une détection efficace (Q étant préférentiellement choisi entre $10^3$ et $10^5$).

Les autres éléments du spectromètre ESR peuvent être tels que ceux décrits plus haut.

En particulier, le micro-résonateur électromagnétique 202, ayant une fréquence de résonance $\omega r$ dans le domaine micro-onde et un facteur de qualité Q et dans lequel est inséré l'échantillon 201 et un dispositif de création d'un champ magnétique B0 dans l'échantillon 201 pour amener à résonance avec la fréquence de résonance $\omega r$ une fréquence $\omega s$ de transition des spins, telle que $\omega s = \gamma B0$, où $\gamma$ est un facteur gyromagnétique des spins, le spectromètre ESR selon l'invention comprend un dispositif de détection de spins recevant des signaux du micro-résonateur électromagnétique 202 et de l'échantillon 201.

Le dispositif de détection de spins comprend au moins un amplificateur bas-bruit 303 fonctionnant à une température comprise entre 1 et 10K, une série d'amplificateurs 304 et un démodulateur 305 fonctionnant à température ambiante, comme représenté sur la figure 4.

On décrira maintenant, en référence à la figure 4, un deuxième aspect de l'invention, qui contribue également à augmenter la sensibilité de détection, et est donc avantageusement mis en œuvre avec le nano-résonateur 202 décrit ci-dessus en référence à la figure 3 pour accroître la sensibilité de ce dernier.

Selon cet autre aspect de l'invention, on utilise un amplificateur paramétrique Josephson qui est un type d'amplificateur micro-onde, récemment développé pour des applications d'information quantique, et dont l'intérêt majeur est d'avoir la meilleure performance de bruit possible puisqu'il atteint la limite de ce qui est autorisé par la physique quantique, c'est-à-dire : n = 0,5 à 1.

Les amplificateurs appelés « amplificateurs paramétriques Josephson » (JPA) sont réalisés à partir de circuits supraconducteurs contenant des jonctions Josephson. Ils fonctionnent typiquement à des températures T telles que $T \leq \hbar \omega r / k_B$, où $\hbar$ est la constante de Planck réduite et $k_B$ est la constante de Boltzmann (dont la valeur est $k_B = 1,38$ J/K = $1,38 \times 10^{-23}$ $m^2kgs^{-2}K^{-1}$).

Ceci correspond à des températures de 10 à 200 mK pour des fréquences de 5 à 10 GHz, et à des températures de 1 à 3 K pour des fréquences de 20 à 40 GHz. Ils ont été utilisés dans diverses expériences, mais pas pour des mesures de résonance magnétique à haute sensibilité.

On peut se référer notamment à l'article de M.A. Castellanos-Beltran, K.W. Lehnert, Appl. Phys. Lett. 91, 083509 (2007) et à l'article de N. Bergeal et al., Nature 465, 64 (2010).

Selon l'invention, il a été trouvé que, pour des mesures de résonance magnétique à haute sensibilité, il est intéressant d'utiliser un JPA dans le régime « dégénéré », où une seule quadrature est amplifiée sans aucun bruit rajouté par l'amplificateur, en réglant l'amplificateur afin d'amplifier la quadrature sur laquelle l'écho de spin est émis. Dans ce régime, le seul bruit limitant la sensibilité de la mesure est le bruit quantique du vide ce qui correspond à n=0,5.

Si l'on se reporte à la figure 4, on voit que, à partir d'un ensemble 301 comprenant un résonateur et un échantillon, qui peut être avantageusement constitué par un résonateur 202 et un échantillon 201 tels que précédemment décrits en référence aux figures 3 et 3A pour obtenir une sensibilité maximale, mais pourrait aussi être réalisé de façon classique sans la constriction 220 du résonateur 202, les signaux induits dans le résonateur soumis à un champ magnétique B0 comme indiqué plus haut sont appliqués à un amplificateur paramétrique Josephson 302 (amplificateur JPA) placé, comme l'ensemble 301, dans un environnement dont la température est celle qui est adaptée à l'amplificateur 302 comme indiqué plus haut.

La sortie de l'amplificateur JPA 302 est reliée à l'entrée d'un amplificateur bas-bruit 303, lui-même placé dans un environnement à une température entre 1 et 10 K. La sortie de l'amplificateur bas-bruit 303 est reliée à l'entrée d'une série d'amplificateurs 304 associée à un démodulateur 305 mettant en œuvre un oscillateur local. L'ensemble de la série d'amplificateurs 304 et du démodulateur 305 est placé à la température ambiante, par exemple de l'ordre de 300 K.

La figure 5 illustre un perfectionnement du mode de réalisation de la figure 4.

Dans le mode de réalisation de la figure 5, on utilise un dispositif générant un vide comprimé (appelé aussi « vide squeezé ») afin d'augmenter encore d'un facteur pouvant aller jusqu'à un ordre de grandeur la sensibilité du spectromètre. Le vide squeezé est un état quantique du champ électromagnétique dans lequel le bruit sur l'une des deux quadratures est réduit d'un facteur S par rapport au bruit quantique du vide, c'est-à-dire que le nombre de photons de bruit rajouté devient $n=0,5/S$. Pratiquement, on peut atteindre S=10 à 100. On choisit la quadrature squeezée de manière à ce qu'elle corresponde à celle sur laquelle l'écho de spin est émis. La sensibilité du spectromètre augmente alors encore d'un facteur $\sqrt{S}$, c'est-à-dire potentiellement d'un ordre de grandeur de plus.

Le vide squeezé est généré par un amplificateur de type JPA 306 supplémentaire en mode dégénéré, placé de telle sorte que sa sortie soit connectée à l'entrée de l'ensemble 301 comprenant le résonateur et l'échantillon dans le spectromètre (cf figure 5). Ce perfectionnement est utile dans le cas où le signal d'écho est ensuite amplifié par un amplificateur 302 de type JPA à la limite quantique comme indiqué précédemment en référence à la figure 4. L'écho non-bruyant obtenu en sortie de l'amplificateur 302 de type JPA à la limite quantique est ensuite amplifié par les amplificateurs 303 et 304 et démodulé par le démodulateur 305 comme illustré sur la figure 4 et ces éléments n'ont pas été représentés à nouveau sur la figure 5.

En combinant les trois modes de réalisation des figures 3 à 5, on atteint (pour g = $2\pi$ x 5 kHz, T = 10 mK, S = 100, Q = $10^5$) : $N_{min}$=0,5. Cela signifie qu'il devient possible d'effectuer des mesures de spectroscopie EPR sur n'importe quel spin électronique à l'échelle du spin unique.

L'invention vise ainsi à accroître très significativement la sensibilité d'une chaîne de détection par résonance paramagnétique électronique (RPE) (en anglais « electron spin resonance » (ESR)) qui permet de mesurer le moment magnétique de spin d'électrons d'un échantillon de matière à tester.

La sensibilité revient à quantifier le nombre de spins électroniques détectés, et se mesure soit en spins/$\sqrt{Hz}$ ($10^9$ spins/$\sqrt{Hz}$ à 300 K pour des appareils commerciaux) soit en nombre de spins électroniques détectés en un seul écho (typiquement $10^{13}$ spins à 300 K avec des appareils commerciaux). On souligne que les installations expérimentales évaluent cette sensibilité en nombre de spins pour un écho, ces deux quantités étant reliées par le taux de répétition, qui lui-même est fixé par le temps de relaxation en énergie des spins $T_1$ qui peut dépendre du type de spin considéré. La meilleure sensibilité atteinte en laboratoire est N1écho≈ $5x10^7$ spins à 1 ou 2 K.

En pratique, cela se passe dans des résonateurs planaires supraconducteurs, où un guide d'ondes confine un résonateur planaire de manière à constituer un résonateur de très haut coefficient de qualité (Q ≈ $10^4$. La sortie du résonateur planaire est habituellement appliquée directement à un amplificateur à faible bruit refroidi à une température comprise entre 1 et 10 K, tel que l'amplificateur 303 de la figure 4. L'invention dans le mode de réalisation de la figure 4 consiste à introduire entre d'une part l'ensemble 301 formé par le résonateur et l'échantillon et d'autre part l'amplificateur 303 un dispositif issu de la physique quantique, à savoir l'amplificateur JPA 302 qui est un « amplificateur à la limite quantique ». Cet « amplificateur à la limite quantique » a un niveau de bruit extrêmement bas, et améliore le rapport signal sur bruit d'environ 10. L'invention prend en compte tous les types possibles de résonateurs supraconducteurs, dont a priori toutes les formes conviennent, bien qu'un mode de réalisation privilégié soit celui décrit en référence aux figures 3 et 3A.

Dans le mode de réalisation de la figure 5, on ajoute du côté opposé à la sortie du résonateur planaire un second « amplificateur à la limite quantique » (amplificateur JPA 306 de la figure 5), dont le fonctionnement est un peu différent mais qui finalement conduit également à réduire aussi le bruit en générant un état de «vide comprimé » à sa sortie.

Enfin le coefficient de qualité de la cavité est aussi un point déterminant.

Le cœur de l'invention consiste en un résonateur micro-onde supraconducteur planaire, destiné à mesurer un ensemble de spins couplés au champ magnétique oscillant du résonateur. Le résonateur peut être fabriqué dans un matériau permettant l'application de champs magnétiques allant jusqu'à 1 Tesla tout en préservant un fort facteur de qualité (entre $10^4$ et $10^5$).

En résumé, afin d'augmenter la sensibilité de ce spectromètre (c'est-à-dire le nombre minimal de spins pouvant être détectés en une seconde), les mesures suivantes sont préconisées conformément à l'invention :
L'utilisation d'un amplificateur micro-onde à la limite quantique 302 pour amplifier le signal d'écho de spins. Cela augmente d'un facteur 10 à 50 le rapport signal à bruit, et donc la sensibilité du spectromètre, c'est-à-dire le nombre minimal de spins pouvant être détectés. A la température de 10mK (température atteinte dans un cryostat à dilution commercial), la sensibilité atteinte est estimée à $10^3$ spins en un seul écho, ce qui représente un gain de quatre ordres de grandeur par rapport aux meilleures performances publiées.

Dans ce cas, la sensibilité est encore accrue avec l'éclairage du spectromètre avec un vide squeezé, généré par un amplificateur paramétrique 306 en entrée du spectromètre. Le vide squeezé diminue le bruit sur l'une des quadratures du signal micro-onde. En choisissant la phase de ce vide squeezé de telle façon qu'elle coïncide avec la phase de l'écho de spin, le rapport signal-sur-bruit sera encore augmenté d'un facteur qui peut aller jusqu'à 10.

Enfin pour augmenter de manière encore plus forte la sensibilité, pour des échantillons 201 de très petite taille (de l'ordre de 100 nm ou 200 nm ou moins), il est possible d'introduire une constriction 220 au sein du résonateur 202, le plus proche possible de l'échantillon 201. Il est ainsi possible d'atteindre une sensibilité correspondant à la détection d'un unique spin en moins d'une seconde de temps d'acquisition.

**Revendications**

1. Dispositif de spectroscopie de résonance de spin de très haute sensibilité, pour la détection et la caractérisation de spins électroniques dans un échantillon donné (201), comprenant un micro-résonateur électromagnétique (202), ayant une fréquence de résonance $\omega r$ dans le domaine micro-onde et un facteur de qualité Q et dans lequel est inséré l'échantillon (201), un dispositif de création d'un champ magnétique B0 dans l'échantillon (201) configuré pour amener à résonance avec la fréquence de résonance $\omega r$ une fréquence $\omega s$ de transition des spins, telle que $\omega s = \gamma B0$, où $\gamma$ est un facteur gyromagnétique des spins, un dispositif de détection de spins configuré pour recevoir des signaux du micro-résonateur électromagnétique (202) associé à l'échantillon (201) et comprenant au moins un amplificateur bas-bruit (303) configuré pour fonctionner à une température entre 1 et 10K, une série d'amplificateurs (304) et un démodulateur (305) configurés pour fonctionner à température ambiante, **caractérisé en ce que** le micro-résonateur électromagnétique (202) est en métal supraconducteur et est réalisé à l'échelle nanométrique en comprenant une zone active constituée par une constriction (220) essentiellement parallélépipédique avec une épaisseur comprise entre 8 et 30 nm, une largeur comprise entre 10 et 500 nm et une longueur comprise entre 100 et 5000 nm, ledit échantillon (201) étant disposé sur ladite constriction (220), les spins présents au sein de ladite zone active (201) étant couplés avec une constante de couplage de 1 à 10 kHz.

2. Dispositif selon la revendication 1, **caractérisé en ce que** le micro-résonateur (202) est réalisé :

   - en niobium, NbN, ou en NbTiN pour un fonctionnement en dessous de 5K ;
   - en aluminium pour un fonctionnement en dessous de 200 mK ; ou
   - en TiN pour un fonctionnement en dessous de 2K.

3. Dispositif selon la revendication 1 ou la revendication 2, **caractérisé en ce qu'**il comprend en outre un amplificateur paramétrique Josephson (303) disposé en amont dudit amplificateur bas-bruit (302) et configuré pour fonctionner à des températures T vérifiant $T \leq \eta \omega r / k_B$ où $\hbar$ est la constante de Planck réduite et $k_B$ est la constante de Boltzmann.

4. Dispositif selon la revendication 3, **caractérisé en ce qu'**il comprend en outre un amplificateur paramétrique Josephson (306) supplémentaire configuré pour fonctionner à des températures $T \leq \eta \omega r / k_B$ disposé de telle sorte que sa sortie soit connectée à l'entrée dudit micro-résonateur (202) afin de produire un vide comprimé qui est un état quantique du champ électromagnétique dans lequel le bruit sur l'une des deux quadratures est réduit par rapport au bruit quantique du vide.

5. Dispositif selon l'une quelconque des revendications 1 à 4, **caractérisé en ce que** le dispositif de détection de spins est du type à onde continue et comprend un dispositif d'injection d'un signal micro-onde à la fréquence $\omega r$ dans le micro-résonateur électromagnétique (202).

6. Dispositif selon l'une quelconque des revendications 1 à 4, **caractérisé en ce que** le dispositif de détection de spins est du type à ondes pulsées et comprend un dispositif d'injection de séquences d'impulsions brèves de micro-onde à la fréquence $\omega r$ dans le micro-résonateur électromagnétique (202) configuré pour exercer une rotation du spin d'un angle de Rabi bien défini.

7. Procédé de spectroscopie de résonance de spin de très haute sensibilité, pour la détection et la caractérisation de spins électroniques dans un échantillon donné (201), comprenant une étape de réalisation d'un micro-résonateur électromagnétique (202), ayant une fréquence de résonance $\omega r$ dans le domaine micro-onde et un facteur de qualité Q et dans lequel est inséré l'échantillon (201), une étape de création d'un champ magnétique B0 dans l'échantillon (201) pour amener à résonance avec la fréquence de résonance $\omega r$ une fréquence $\omega s$ de transition des spins, telle que $\omega s = \gamma B0$, où $\gamma$ est un facteur gyromagnétique des spins, une étape de détection de spins recevant des signaux du micro-résonateur électromagnétique (202) auquel est associé l'échantillon en utilisant au moins un amplificateur bas-bruit (303) configuré pour fonctionner à une température entre 1 et 10K, ainsi qu'une série d'amplificateurs (304) et un démodulateur (305) configurés pour fonctionner à température ambiante, **caractérisé en ce que** dans l'étape de réalisation du micro-résonateur électromagnétique (202) on choisit un micro-résonateur électromagnétique en métal supraconducteur qui est réalisé à l'échelle nanométrique en comprenant une zone active constituée par une constriction (220) essentiellement parallélépipédique dont les dimensions sont : une épaisseur de 8 à 30 nm, une largeur de 10 à 500 nm, et une longueur comprise entre 100 et 5000 nm, ledit échantillon (201) étant disposé sur ladite constriction (220), les spins présents au sein de ladite zone active (201) étant couplés avec une constante de couplage de 1 à 10 kHz.

8. Procédé selon la revendication 7, **caractérisé en ce que** dans l'étape de détection de spins, on dispose en outre en amont dudit amplificateur bas-bruit (303) un amplificateur paramétrique Josephson (302) configuré pour fonctionner à des températures T vérifiant $T \leq \eta \omega r / k_B$, où $\hbar$ est la constante de Planck réduite et $k_B$ est la constante de Boltzmann.

9. Procédé selon la revendication 8, **caractérisé en ce que** dans l'étape de réalisation d'un micro-résonateur électromagnétique (202), on dispose un amplificateur paramétrique Josephson (306) supplémentaire configuré pour fonctionner à des températures T vérifiant $T \leq \eta \omega r / k_B$, de telle sorte que sa sortie soit connectée à l'entrée dudit micro-résonateur (202) afin de produire un vide comprimé qui est un état quantique du champ électromagnétique dans lequel le bruit sur l'une des deux quadratures est réduit par rapport au bruit quantique du vide.

10. Procédé selon la revendication 8 ou la revendication 9, **caractérisé en ce que** les fréquences de mesure sont comprises entre 5 et 10 GHz et la température T est comprise entre 10 et 200 mK.

11. Procédé selon la revendication 8 ou la revendication 9, **caractérisé en ce que** les fréquences de mesure sont comprises entre 20 et 40 GHz et la température T est comprise entre 1 et 3 K.

**Patentansprüche**

1. Spinresonanzspektroskopie-Vorrichtung mit sehr hoher Empfindlichkeit zum Nachweis und zur Charakterisierung von Elektronenspins in einer gegebenen Probe (201), umfassend einen elektromagnetischen Mikroresonator (202), der eine Resonanzfrequenz $\omega r$ im Mikrowellenbereich und einen Qualitätsfaktor Q aufweist und in den die Probe (201) eingesetzt ist, eine Vorrichtung zur Erzeugung eines Magnetfeldes B0 in der Probe (201), die dazu konfiguriert ist, eine Übergangsfrequenz $\omega s$ der Spins mit der Resonanzfrequenz $\omega r$ in Resonanz zu bringen, so dass $\omega s = \gamma B0$ ist, wobei $\gamma$ ein gyromagnetischer Faktor der Spins ist, eine Spindetektionsvorrichtung, die dazu konfiguriert ist, Signale von dem elektromagnetischen Mikroresonator (202) zu empfangen, der mit der Probe (201) verbunden ist, und die mindestens einen rauscharmen Verstärker (303) umfasst, der dazu konfiguriert ist, bei einer Temperatur zwischen 1 und 10 K zu arbeiten, eine Reihe von Verstärkern (304) und einen Demodulator (305), die dazu konfiguriert sind, bei Raumtemperatur zu arbeiten, **dadurch gekennzeichnet, dass** der elektromagnetische Mikroresonator (202) aus supraleitendem Metall besteht und im Nanomaßstab hergestellt ist, indem er eine aktive Zone umfasst, die aus einer im Wesentlichen parallelepipedischen Einschnürung (220) mit einer Dicke zwischen 8 und 30 nm, einer Breite zwischen 10 und 500 nm und einer Länge zwischen 100 und 5000 nm besteht, wobei die Probe (201) auf der Einschnürung (220) angeordnet ist und die in der aktiven Zone (201) vorhandenen Spins mit einer Kopplungskonstante von 1 bis 10 kHz gekoppelt sind.

2. Vorrichtung nach Anspruch 1, **dadurch gekennzeichnet, dass** der Mikroresonator (202) hergestellt ist aus:

    - Niob, NbN oder NbTiN für einen Betrieb unter 5 K,
    - Aluminium für einen Betrieb unter 200 mK oder
    - TiN für einen Betrieb unter 2 K.

3. Vorrichtung nach Anspruch 1 oder Anspruch 2, **dadurch gekennzeichnet, dass** sie ferner einen parametrischen Josephson-Verstärker (303) umfasst, der stromaufwärts des rauscharmen Verstärkers (302) angeordnet und dazu konfiguriert ist, bei Temperaturen T zu arbeiten, die $T \leq \hbar \omega r / k_B$ erfüllen, wobei $\hbar$ die reduzierte Planck-Konstante und $k_B$ die Boltzmann-Konstante darstellt.

4. Vorrichtung nach Anspruch 3, **dadurch gekennzeichnet, dass** sie ferner einen zusätzlichen parametrischen Josephson-Verstärker (306) umfasst, der dazu konfiguriert ist, bei Temperaturen $T \leq \hbar \omega r / k_B$ zu arbeiten, und der so angeordnet ist, dass sein Ausgang mit dem Eingang des Mikroresonators (202) verbunden ist, um ein komprimiertes Vakuum zu erzeugen, das ein Quantenzustand des elektromagnetischen Feldes ist, in dem das Rauschen auf einer der beiden Quadraturen relativ zum Vakuumquantenrauschen reduziert ist.

5. Vorrichtung nach einem der Ansprüche 1 bis 4, **dadurch gekennzeichnet, dass** die Spindetektionsvorrichtung vom Typ kontinuierliche Welle ist und eine Vorrichtung zur Injektion eines Mikrowellensignals mit der Frequenz ωr in den elektromagnetischen Mikroresonator (202) umfasst.

6. Vorrichtung nach einem der Ansprüche 1 bis 4, **dadurch gekennzeichnet, dass** die Spindetektionsvorrichtung vom Typ Impulswelle ist und eine Vorrichtung zur Injektion von Sequenzen von kurzen Mikrowellenimpulsen mit der Frequenz ωr in den elektromagnetischen Mikroresonator (202) umfasst, die dazu konfiguriert ist, den Spin um einen wohldefinierten Rabi-Winkel rotieren zu lassen.

7. Spinresonanzspektroskopie-Verfahren mit sehr hoher Empfindlichkeit zum Nachweis und zur Charakterisierung von Elektronenspins in einer gegebenen Probe (201), umfassend einen Schritt der Herstellung eines elektromagnetischen Mikroresonators (202), der eine Resonanzfrequenz ωr im Mikrowellenbereich und einen Qualitätsfaktor Q aufweist und in die die Probe (201) eingesetzt ist, einen Schritt des Erzeugens eines Magnetfeldes B0 in der Probe (201), um eine Übergangsfrequenz ωs der Spins in Resonanz mit der Resonanzfrequenz ωr zu bringen, so dass ωs = γB0 ist, wobei γ ein gyromagnetischer Faktor der Spins ist, einen Schritt des Detektierens von Spins, wobei Signale von dem elektromagnetischen Mikroresonator (202) empfangen werden, mit dem die Probe verbunden ist, unter Verwendung von mindestens einem rauscharmen Verstärker (303), der dazu konfiguriert ist, bei einer Temperatur zwischen 1 und 10 K zu arbeiten, sowie einer Reihe von Verstärkern (304) und einem Demodulator (305), die dazu konfiguriert sind, bei Raumtemperatur zu arbeiten, **dadurch gekennzeichnet, dass** im Schritt der Herstellung des elektromagnetischen Mikroresonators (202) ein elektromagnetischer Mikroresonator aus supraleitendem Metall gewählt wird, der im Nanomaßstab hergestellt ist, indem er eine aktive Zone umfasst, die aus einer im Wesentlichen parallelepipedischen Einschnürung (220) besteht, deren Abmessungen sind: eine Dicke von 8 bis 30 nm, eine Breite von 10 bis 500 nm und eine Länge zwischen 100 und 5000 nm, wobei die Probe (201) auf der Einschnürung (220) angeordnet ist und die in der aktiven Zone (201) vorhandenen Spins mit einer Kopplungskonstante von 1 bis 10 kHz gekoppelt sind.

8. Verfahren nach Anspruch 7, **dadurch gekennzeichnet, dass** im Schritt des Detektierens von Spins ferner stromaufwärts des rauscharmen Verstärkers (303) ein parametrischer Josephson-Verstärker (302) angeordnet ist, der dazu konfiguriert ist, bei Temperaturen T zu arbeiten, die $T \leq \hbar\omega r/k_B$ erfüllen, wobei $\hbar$ die reduzierte Planck-Konstante und $k_B$ die Boltzmann-Konstante ist.

9. Verfahren nach Anspruch 8, **dadurch gekennzeichnet, dass** in dem Schritt der Herstellung eines elektromagnetischen Mikroresonators (202) ein zusätzlicher parametrischer Josephson-Verstärker (306) angeordnet wird, der dazu konfiguriert ist, bei Temperaturen T zu arbeiten, die $T \leq \hbar\omega r/k_B$ erfüllen, so dass sein Ausgang mit dem Eingang des Mikroresonators (202) verbunden ist, um ein komprimiertes Vakuum zu erzeugen, das ein Quantenzustand des elektromagnetischen Feldes ist, in dem das Rauschen auf einer der beiden Quadraturen relativ zum Vakuumquantenrauschen reduziert ist.

10. Verfahren nach Anspruch 8 oder Anspruch 9, **dadurch gekennzeichnet, dass** die Messfrequenzen zwischen 5 und 10 GHz liegen und die Temperatur T zwischen 10 und 200 mK beträgt.

11. Verfahren nach Anspruch 8 oder Anspruch 9, **dadurch gekennzeichnet, dass** die Messfrequenzen zwischen 20 und 40 GHz liegen und die Temperatur T zwischen 1 und 3 K beträgt.

**Claims**

1. A very-high-sensitivity spin-resonance spectroscopy device for detecting and characterizing electron spins in a given sample (201), comprising an electromagnetic microresonator (202) having a resonant frequency ωr in the microwave domain and a quality factor Q and into which the sample (201) is inserted, a device for creating a magnetic field B0 in the sample (201) in order to bring into resonance with the resonant frequency ωr a transition frequency ωs of the spins, such that ωs=γB0, where γ is a gyromagnetic ratio of the spins, and a spin-detecting device receiving signals from the electromagnetic microresonator (202) that is associated with the sample (201) and comprising at least one low-noise amplifier (303) operating at a temperature between 1 and 10 K, and a series of amplifiers (304) and a demodulator (305) operating at room temperature, **characterized in that** the electromagnetic microresonator (202) is made of superconductive metal and is produced on the nanoscale **in that** it comprises an active zone consisting of an essentially parallelepipedal constriction (220) with a thickness comprised between 8 and 30 nm, a width comprised between 10 and 500 nm and a length comprised between 100 and 5000 nm, said sample (201) being placed on the constriction (220), the spins present in said active zone (201) being coupled with a coupling constant from 1 to 10 kHz.

2. The device as claimed in claim 1, **characterized in that** the microresonator (202) is made:

   - of niobium, NbN, NbTiN for operation below 5K;

- of aluminium for operation below 200mK ; or
- of TiN for operation below 2K.

3. The device as claimed in claim 1 or claim 2, **characterized in that** it furthermore comprises a Josephson parametric amplifier (303) that is placed upstream of said low-noise amplifier (302) and that operates at temperatures T respecting $T \leq \hbar \omega r / k_B$ where $\hbar$ is the reduced Planck's constant and $k_B$ is Boltzmann's constant.

4. The device as claimed in claim 3, **characterized in that** it furthermore comprises an additional Josephson parametric amplifier (306) operating at temperatures $T \leq \hbar \omega r / k_B$ and placed such that its output is connected to the input of said microresonator (202) in order to produce a squeezed vacuum i.e. a quantum state of the electromagnetic field in which the noise in one of the two quadratures is decreased with respect to the vacuum quantum noise.

5. The device as claimed in any one of claims 1 to 4, **characterized in that** the spin-detecting device is a continuous-wave device and comprises a device for injecting a microwave signal at the frequency ωr into the electromagnetic microresonator (202).

6. The device as claimed in any one of claims 1 to 4, **characterized in that** the spin-detecting device is a pulsed-wave device and comprises a device for injecting sequences of brief pulses of microwave frequency equal to the frequency ωr into the electromagnetic microresonator (202) in order to cause the spin to rotate by a well-defined Rabi angle.

7. A very-high-sensitivity spin-resonance spectroscopy method for detecting and characterizing electron spins in a given sample (201), comprising a step of producing an electromagnetic microresonator (202) having a resonant frequency ωr in the microwave domain and a quality factor Q and into which the sample (201) is inserted, a step of creating a magnetic field B0 in the sample (201) in order to bring into resonance with the resonant frequency ωr a transition frequency ωs of the spins, such that ωs=γB0, where $\gamma$ is a gyromagnetic ratio of the spins, and a spin-detecting step in which signals are received from the electromagnetic microresonator (202) with which the sample is associated via at least one low-noise amplifier (303) operating at a temperature between 1 and 10 K, and a series of amplifiers (304) and a demodulator (305) operating at room temperature, **characterized in that** in the step of producing the electromagnetic microresonator (202) an electromagnetic microresonator made of superconductive metal is chosen, which microresonator is produced on the nanoscale **in that** it comprises an active zone consisting of an essentially parallelepipedal constriction (220) the dimensions of which are: a thickness of 8 to 30 nm, a width of 10 to 500 nm, and a length comprised between 100 and 5000 nm, said sample (201) being placed on the constriction (220), the spins present in said active zone (201) being coupled with a coupling constant from 1 to 10 kHz.

8. The method as claimed in claim 7, **characterized in that**, in the spin-detecting step, a Josephson parametric amplifier (302) is furthermore placed upstream of said low-noise amplifier (303), said Josephson parametric amplifier operating at temperatures T respecting $T \leq \hbar \omega r / k_B$ where $\hbar$ is the reduced Planck's constant and $k_B$ is Boltzmann's constant.

9. The method as claimed in claim 8, **characterized in that**, in the step of producing an electromagnetic microresonator (202), an additional Josephson parametric amplifier (306) operating at temperatures T respecting $T \leq \hbar \omega r / k_B$ is placed such that its output is connected to the input of said microresonator (202) in order to produce a squeezed vacuum i.e. a quantum state of the electromagnetic field in which the noise in one of the two quadratures is decreased with respect to the vacuum quantum noise.

10. The method as claimed in claim 8 or claim 9, **characterized in that** the measurement frequencies are comprised between 5 and 10 GHz and the temperature T is comprised between 10 and 200 mK.

11. The method as claimed in claim 8 or claim 9, **characterized in that** the measurement frequencies are comprised between 20 and 40 GHz and the temperature T is comprised between 1 and 3 K.

FIG.1

FIG.2

**FIG.3**

**FIG.3A**

**FIG.4**

**FIG.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Y. TWIG ; E. SUHOVOY ; A. BLANK.** *Rev. Sci. Inst.,* 2010, vol. 81, 104703
- **Y. ARTZI ; Y. TWIG ; A. BLANK.** *Appl. Phys. Lett.,* 2015, vol. 104, 84104
- **H. MALISSA ; D.I. SCHUSTER ; A.M. TYRYSHKIN ; A.A. HOUCK ; S.A. LYON.** *Rev. of Sci. Instr.,* 2013, vol. 84, 025116
- **A.J. SIGILLITO et al.** *Appl. Phys. Lett.,* 2014, vol. 104, 222407
- **M.A. CASTELLANOS-BELTRAN ; K.W. LEHNERT.** *Appl. Phys. Lett.,* 2007, vol. 91, 083509
- **N. BERGEAL et al.** *Nature,* 2010, vol. 465, 64